Europäisches Patentamt

European Patent Office

Office européen des brevets

Veröffentlichungsnummer: **0 284 818**
**A1**

# EUROPÄISCHE PATENTANMELDUNG

(21) Anmeldenummer: **88103343.5**

(51) Int. Cl.4: **H01L 21/60**

(22) Anmeldetag: **04.03.88**

(30) Priorität: **03.04.87 CH 1287/87**

(43) Veröffentlichungstag der Anmeldung:
**05.10.88 Patentblatt 88/40**

(84) Benannte Vertragsstaaten:
**AT CH DE FR GB IT LI NL**

(71) Anmelder: **BBC Brown Boveri AG
Haselstrasse
CH-5401 Baden(CH)**

(72) Erfinder: **Kloucek, Franz, Dr.
Brückenstrasse 10
CH-5430 Wettingen(CH)**
Erfinder: **Larsson, Per-Olof
Waldeggweg 2
CH-5415 Nussbaumen(CH)**
Erfinder: **Vogt, Ernst
Obere Leestrasse 293
CH-5236 Remigen(CH)**

(54) **Verfahren zum Herstellen eines Schichtverbunds sowie Vorrichtung zur Durchführung eines Verfahrens.**

(57) Bei einem Verfahren zum stoffschlüssigen Verbinden von dünnen, grossflächigen Scheiben unterschiedlicher Wärmeausdehnung bei erhöhten Temperaturen werden die beim späteren Abkühlen auftretenden Verwölbungen des Schichtverbunds durch eine geeignete Vorbiegung in entgegengesetzter Richtung zumindest teilweise kompensiert.

Eine Vorrichtung zur Durchführung des Verfahrens nutzt zum Erzeugen der Vorbiegung die unterschiedliche Wärmeausdehnung eines Gehäuses (1) und eines ringförmigen Wärmedehnelements (3).

**FIG.1**

EP 0 284 818 A1

## Verfahren zum Herstellen eines Schichtverbunds sowie Vorrichtung zur Durchführung eines Verfahrens

### Technisches Gebiet

Die Erfindung bezieht sich auf das Gebiet der Verbindungstechnik. Sie betrifft insbesondere ein Verfahren zum Herstellen eines Schichtverbunds aus wenigstens zwei dünnen Scheiben unterschiedlicher Wärmeausdehnung, bei welchem Verfahren die Scheiben bei erhöhten Temperaturen über die gesamte Scheibenfläche stoffschlüssig verbunden und anschliessend abgekühlt werden, sowie eine Vorrichtung zur Durchführung des Verfahrens.

### Stand der Technik

Die stoffschlüssige Verbindung dünner, grossflächiger Scheiben mit unterschiedlicher Wärmeausdehnung ist als Technologie in verschiedenen Anwendungsgebieten von grosser Bedeutung.

Eines dieser Anwendungsgebiete ist die Herstellung von Leistungs-Halbleiterbauelementen, bei der beispielsweise grossflächige Metall-Keramik-Verbindungen ($Cu-Al_2O_3$) oder Halbleiter-Metall-Verbindungen (Si-Mo) eine entscheidende Rolle spielen.

Wenn bei einer solchen stoffschlüssigen Verbindung ein Verbindungsprozess eingesetzt wird, der bei deutlich erhöhten Tempera turen abläuft (z.B. das sogenannte "direct bonding"), kommt es beim Abkühlen des fest verbundenen Schichtverbunds wegen der unterschiedlichen Wärmeausdehnungskoeffizienten zu mechanischen Spannungen, die zu einer Verbiegung des Schichtverbunds führen (siehe z.B. M. Wittmer et al. in J. Am. Ceramic Soc., Vol. 65, No. 3, S. 149-153).

Die Verbiegung setzt einerseits die Teile des Schichtverbunds einer unerwünschten mechanischen Belastung aus. Andererseits ist die Verbiegung als Abweichung von der Planarität für die weitere Behandlung des Schichtverbunds (z.B. den Einbau oder nachfolgende Maskenprozesse) von grossem Nachteil.

Man hat aus diesen Gründen seit längerem versucht, einen solchen Schichtverbund verbiegungsfrei herzustellen. Eine Möglichkeit dazu ist beispielsweise aus der EP-A1 0 135 120 bekannt.

In dem genannten Fall, bei dem es sich um einen Keramik-Metall-Schichtverbund handelt, wird die Verbiegung des grossflächigen Verbundes dadurch verhindert, dass die Metallschicht mosaikartig aus kleinflächigen, lose aneinandergrenzenden Metallelementen zusammengesetzt wird und so die thermisch bedingten Verspannungen aufgefangen werden.

Diese bekannte Lösung weist jedoch für viele Zwecke keine ausreichende Stabilität auf, da die mosaikartig zusammengesetzte Schicht zur Festigkeit des Schichtverbunds nur wenig beiträgt. Darüberhinaus bereitet es grössere Schwierigkeiten, eine aus lauter Einzelelementen bestehende Schicht mit einer einstückigen zu verbinden als zwei einstückige Schichten.

### Darstellung der Erfindung

Es ist Aufgabe der vorliegenden Erfindung, ein Verfahren zum Herstellen eines Schichtverbunds sowie eine Vorrichtung zur Durchführung des Verfahrens anzugeben, mit denen es möglich ist, einen Schichtverbund aus durchgängigen Schichten zu schaffen, der eine reduzierte oder gar keine Verbiegung aufweist.

Die Aufgabe wird bei einem Verfahren der eingangs genannten Art dadurch gelöst, dass die beim Abkühlen des Schichtverbunds auftretende Verbiegung durch eine beim Verbindungsvorgang anliegende, in der Richtung entgegengesetzte Vorbiegung zumindest teilweise kompensiert wird.

Der Kern der Erfindung besteht also darin, den Schichtverbund bei den erhöhten Temperaturen, bei denen der Prozess der stoffschlüssigen Verbindung abläuft, und bei denen noch keine thermisch bedingte Verbiegung auftritt, in entgegengesetzer Richtung so stark vorzubiegen, dass die beim Abkühlen auftretende Verbiegung und die Vorbiegung sich zumindest teilweise aufheben.

Ein besonderer Vorteil des erfindungsgemässen Verfahrens ist darin zu sehen, dass durch die Kompensation der Schichtverbund zumindest im Innenbereich weitgehend spannungsfrei ist. Lediglich in einem schmalen Randbereich bleiben Scherspannungen bestehen, die gemäss einer bevorzugten Weiterbildung der Erfindung durch Abtrennen des Randbereichs beseitigt werden können.

Besonders vorteilhaft ist es, zum Erzeugen der Vorbiegung die unterschiedliche Wärmeausdehnung zweier Materialen mit unterschiedlichen Wärmeausdehnungskoeffizienten heranzuziehen. Auf diese Weise kann eine mit zunehmender Temperatur wachsende Vorbiegung erzeugt werden, ohne dass der Schichtverbund zusätzlich (z.B. durch die Drehbewegung einer Schraube) mechanisch belastet wird. Dieser Vorzug wird besonders wichtig, wenn es sich bei der einen Schicht des Schichtverbunds um ein empfindliches Halbleitersubstrat handelt.

Die erfindungsgemässe Vorrichtung zur Durchführun des Verfahrens umfasst

- ein im wesentlichen ringförmiges Gehäuse aus einem Material geringerer Wärmeausdehnung;
- ein konzentrisch in dem Gehäuse angeordnetes ringförmiges Wärmedehnelement aus einem Material grösserer Wärmeausdehnung, welches die Anordnung der Scheiben auf der einen Seite am Scheibenrand abstützt; und
- einen dem Wärmedehnelement gegenüberliegenden Schraubverschluss, welcher mit einem auf seiner Innenseite angeordneten Druckstempel auf die vom Wärmedehnelement abgestützte Anordnung der Scheiben drückt.

Weitere Ausführungsbeispiele ergeben sich aus den Unteransprüchen.

Kurze Beschreibung der Zeichnung

Die Erfindung soll nun nachfolgend im Zusammenhang mit der Zeichnung anhand von Ausführungsbeispielen näher erläutert werden. Es zeigen

Fig. 1 ein bevorzugtes Ausführungsbeispiel für eine Vorrichtung zur Durchführung des erfindungsgemässen Verfahrens;

Fig. 2A Belastungsschema und Biegemomentdiagramm für eine punktförmige Belastung der Scheibenanordnung beim Vorbiegen;

Fig. 2B Belastungsschema und Biegemomentdiagramm für eine entsprechende ringförmige Belastung mit konstantem Biegemoment im Innenbereich; und

Fig. 3 im Vergleich die gemessene Wölbung eines Schichtverbunds ohne Vorbiegung (Kurve A) und mit Vorbiegung (Kurve B).

Wege zur Ausführung der Erfindung

Das erfindungsgemässe Verfahren und die entsprechende Vorrichtung zur Durchführung des Verfahrens werden im Folgenden am Beispiel eines Schichtverbunds aus einem Si-Halbleitersubstrat und einem Mo-Metallsubstrat erläutert. Ein solcher Schichtverbund ist unter der Bezeichnung "Legierkontakt" aus der Technologie der Leistungs-Halbleiterbauelemente bekannt.

Bei der Herstellung eines Legierkontakts wird das grossflächige, dünne Halbleitersubstrat aus Si unter Verwendung von Aluminium als Lot stoffschlüssig mit einem Metallsubstrat gleicher Grösse verbunden. Wegen der thermisch bedingten Spannungen kommen für das Metallsubstrat nur Metalle mit niedriger Wärmedehnung wie Mo oder W in Frage. Da die Herstelltemperaturen für diesen Kontakt deutlich über 400°C liegen (die eutektische Temperatur der an der stoffschlüssigen Verbindung beteiligten eutektischen Al-Si-Legierung beträgt 577°C), kann der Kontakt als Hartlötverbindung betrachtet werden. Als Lot findet bei dem Legierkontakt meist reines Al Verwendung, das beim Bondvorgang etwas Si des Halbleitersubstrats auflöst und damit die bereits erwähnte Al-Si-Legierung als Kontaktschicht bildet.

Handelt es sich bei dem Halbleitersubstrat um einen über das Gate abschaltbaren (GTO = Gate Turn Off) Thyristor, ergibt sich unter Anderem folgendes Problem: Der Legiervorgang, der zum Legierkontakt führt, erfolgt bei so hohen Temperaturen, dass die letzten Fertigungsschritte für die Kathodenseite des GTO-Thyristors nach dem Legieren durchgeführt werden müssen.

Der legierte Schichtverbund aus Si-Halbleitersubstrat und Mo-Metallsubstrat verwölbt sich jedoch beim Abkühlen nach dem Legierprozess wegen der unterschiedlichen Wärmeausdehnungskoeffizienten von Mo ($\alpha$ = 5•10$^{-6}$K$^{-1}$) und Si ($\alpha$ = 2,6•10$^{-6}$K$^{-1}$). Diese Verwölbung, die je nach Scheibendurchmesser und -dicke bis zu mehreren 100 $\mu$m betragen kann, erschwert die letzten Herstellungsschritte für einen GTO-Thyristor unter dem Mask-Aligner und sollte daher möglichst klein, insbesondere jedoch kleiner als etwa 50 $\mu$m, gehalten werden. Als Mass für die Verwölbung wird dabei die Abweichung (s) zwischen der Flächenmitte des Schichtverbunds und der Ebene durch seine Kante verwendet.

Für verschiedene Scheibendurchmesser (38 und 77 mm) und unterschiedliche Dicken der Mo-Metallsubstrate (1; 2 und 2,5 mm) sind die Verwölbungen sowohl in einer vereinfachten elastischen Rechnung mittels eines Rechenprogramms berechnet, als auch an hergestellten Legierkontakten gemessen worden. Die Dicke der Halbleitersubstrate lag dabei in der Grössenordnung von 0,5 mm. Die Berechnung erfolgte weiterhin unter der Annahme einer Abkühlung von einer effektiven Temperatur von 400°C.

Die Ergebnisse von Rechnung und Messung sind im Vergleich in der nachfolgenden Tabelle 1 dargestellt:

Tabelle 1:

| Scheiben-∅ | Dicke Mo-Substrat | s(Rechnung) | s(Messung) |
|---|---|---|---|
| 77 | 2,5 | 211 | 200 |
| 38 | 1 | 133 | 135 |
| 38 | 2 | 59 | 50 |
| [mm] | [mm] | [µm] | [µm] |

Die berechneten und experimentellen Ergebnissen für die Verwölbung s stimmen hinreichend überein, wenn die Berechnung unter erwähnter Annahme erfolgt, dass der Schichtverbund von einer effektiven Temperatur von 400°C auf Raumtemperatur abgekühlt wird. Eine angenommene Abkühlung von der eutektischen Temperatur von 577°C würde dagegen zu grosse Werte liefern. Gerechtfertigt wird dieses Vorgehen dadurch, dass das Rechenprogramm eine starre Kopplung von Halbleiter-und Metallsubstrat voraussetzt, in der Realität jedoch unterhalb 577°C bereits kleine mechanische Spannungen genügen, um im Al-Si-Lot eine plastische Verformung durch Kriechen zu erzeugen. Auch die sich ergebenden Spannungswerte im Inneren des Schichtverbunds haben unter der erstgenannten Annahme eine realistische Grössenordnung.

Die gemessene Verwölbung für den dritten in Tabelle 1 aufgeführten Fall (s = 50 µm) liegt gerade an der Grenze des vorher genannten Zielwertes für den sinnvollen Einsatz eines Mask-Aligners.

Dünnere Mo-Metallsubstrate (Dicke kleiner 2 mm) hätten jedoch eine erhöhte Verwölbung zur Folge und könnten damit nicht eingesetzt werden.

Entsprechend wäre im ersten Fall der Tabelle 1 nach der Rechnung ein Mo-Metallsubstrat mit einer Dicke von 6,5 mm nötig, um die Verwölbung (Verbiegung) von den gemessenen 200 µm auf ein tolerierbares Mass zu reduzieren.

In jeden Fall haben aber relativ dicke Mo-Metallsubstrate für den Thyristor eine Reihe von Nachteilen:
- hoher Wärmewiderstand beim Betrieb des Thyristors;
- hohe Kosten von dicken Mo-Metallsubstraten; und
- erschwerte Bedingungen bei der Herstellung des Legierkontaktes wegen der grösseren thermischen Masse.

Nach der Erfindung wird nun die Verwölbung nicht durch die Wahl eines hinreichend dicken Metallsubstrats aufgefangen, sondern (bei Dicken des Metallsubstrats < 5 mm, vorzugsweise < 2,5 mm) durch Anlegen einer in entgegengesetzter Richtung wirkenden Vorbiegung bei den erhöhten Legiertemperaturen.

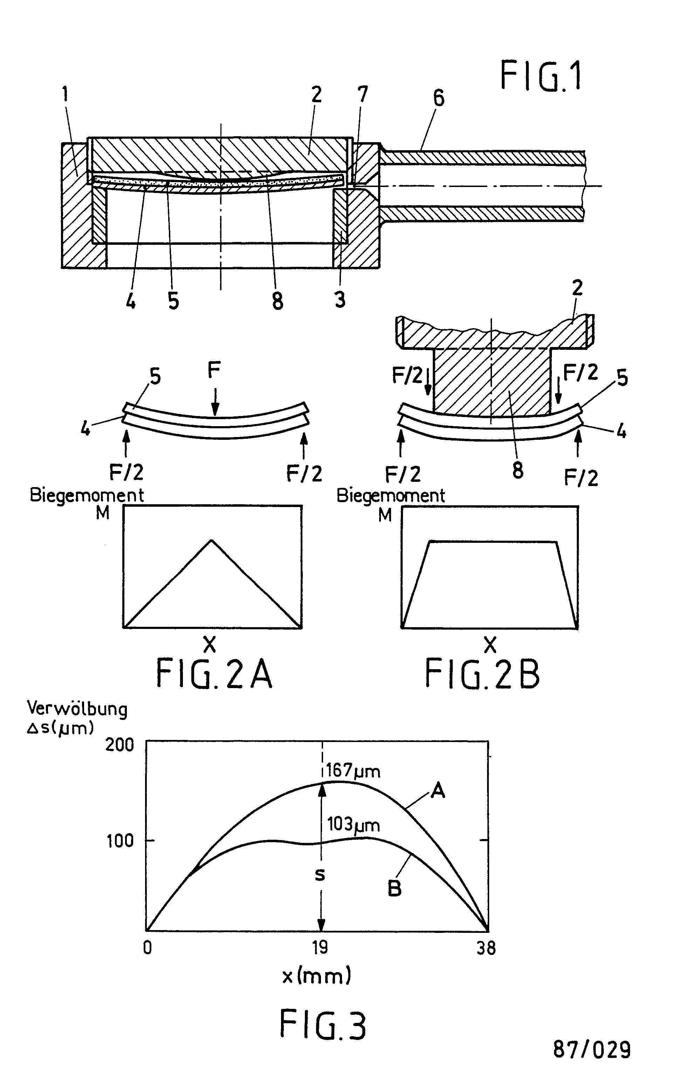

Das bevorzugte Ausführungsbeispiel einer Vorrichtung, mit der auf kleinem Raum und bei ausgezeichneten Wärmefluss-Verhältnissen (für einen ungestörten Legiervorgang) diese Verbiegung einfach und sicher erzeugt werden kann, ist in Fig. 1 dargestellt.

Die dort gezeigte kompakte Belastungsvorrichtung besteht aus einem im wesentlichen ringförmigen Gehäuse 1 mit einer seitlich angebrachten, rohrartigen Halterung 6.

Das Gehäuse 1 ist nach unten hin offen und weist im Inneren auf der Unterseite einen Absatz auf, der ein ringförmiges Wärmedehnelement 3 trägt, welches konzentrisch im Gehäuse 1 angeordnet ist.

Nach oben hin ist in das Gehäuse 1 ein Innengewinde eingeschnitten, das zu einem deckelartigen Schraubverschluss 2 gehört, der das Gehäuse 1 auf der Oberseite verschliesst.

Zwischen dem Wärmedehnelement 3 und dem Schraubverschluss 2 ist die Anordnung aus Metallsubstrat 4 (Mo-Scheibe) und Halbleitersubstrat 5 (si-Scheibe) gelagert, welche durch Legieren stoffschlüssig zu einem Schichtverbund verbunden werden sollen. Die Abmessungen von Gehäuse 1, Wärmedehnelement 3 und den zu verbindenden Scheiben (4,5) sind so aufeinander abgestimmt, dass die Scheiben mit ihrem Rand auf dem Wärmedehnelement 3 aufliegen und dann auf der einen Seite am Scheibenrand abgestützt werden.

4

Auf der Innenseite des Schraubverschlusses 2 ist ein Druckstempel 8 in Form eines Kugelsegments angeordnet. Der Druckstempel 8 übt, wenn der Schraubverschluss 2 hinreichend weit in das Gehäuse 1 hineingedreht ist, eine punktförmige Belastung auf die Mitte der Scheibenanordnung aus, welche die Scheiben nach unten hin durchbiegt.

Da bei der in Fig. 1 gewählten Darstellung das Metallsubstrat 4 in Form einer Mo-Scheibe mit seinem gegenüber Si doppelt so grossen Wärmeausdehnungskoeffizienten unter dem Halbleitersubstrat 5 liegt, würde die beim Abkühlen nach dem Legieren auftretende Verbiegung den Schichtverbund nach oben hin verwölben. Die durch Schraubverschluss 2 und Wärmedehnelement 3 verursachte Vorbiegung ist also der thermisch bedingten Verbiegung genau entgegengesetzt.

Das Anlegen einer für die Vorbiegung ausreichenden Belastung geschieht jedoch nicht durch das Eindrehen des Schraubverschlusses 2, sondern durch die unterschiedliche Ausdehnung von Wärmedehnelement 3 und Gehäuse 1 beim Erwärmen der Anordnung auf die für den Legiervorgang notwendigen Temperaturen.

Um dies zu erreichen, ist das Gehäuse 1 aus einem Material mit geringerer Wärmeausdehnung und das Wärmedehnelement 3 aus einem Material mit grösserer Wärmeausdehnung gefertigt. Hierfür kommt eine Vielzahl von Material-Paarungen in Betracht. In der Praxis hat es sich bewährt, das Gehäuse 1 speziell aus einer Molybdänbasislegierung herzustellen, die unter dem Namen "Climelt TZM" von der US-Firma Climax Molybdenum Co. of Michigan verkauft wird und bei einem Mindestgehalt von über 99 % Mo einen Wärmeausdehnungskoeffizienten bei 700°C von $\alpha = 4,8 \bullet 10^{-6} K^{-1}$ aufweist (Betriebsblatt CMX-TZM-DG-1) sowie eine für den Legiervorgang vorteilhafte gute Wärmeleitfähigkeit.

Für die Anfertigung des Wärmedehnelements 3 hat sich als Material eine Nickelbasislegierung Ni50CoMoAl bewährt, die unter dem Namen "Nimonic 105" im Handel ist und einen Wärmeausdehnungskoeffizienten bei 400°C von $\alpha = 13,4 \bullet 10^{-6} K^{-1}$ besitzt.

Beim Herstellen des Legierkontaktes liegt nun die Scheiben-Anordnung auf dem Wärmedehnelement 3 auf und wird durch den Druckstempel 8 des Schraubverschlusses 2 nur leicht vorbelastet. Beim Hochheizen dehnt sich dann das Wärmedehnelement 3 stärker aus als das Gehäuse 1 und verbiegt die dazwischenliegenden Scheiben. Die Verwölbung s ergibt sich dabei aus der Temperaturänderung ..T, der Höhe h des Wärmedehnelementes 3 und der Differenz der Wärmeausdehnungskoeffizienten von Wärmedehnelement 3 ($\alpha_w$) und Gehäuse 1 ($\alpha_G$) zu:

$$s = h \bullet ..T (\alpha_w - \alpha_G)$$

Obgleich sich die Vorbiegung der Scheiben auch rein mechanisch durch den Schraubverschluss realisieren lässt, ist die thermisch verursachte Belastung mittels Wärmedehnelement gerade bei der Herstellung von Si-Mo-Legierkontakten von besonderem Vorteil: Das empfindliche Halbleitersubstrat wird durch eine reibende Drehbewegung des Schraubverschlusses nicht zusätzlich belastet. Darüberhinaus lässt sich die Vorrichtung nach dem Legiervorgang leicht öffnen.

Mit einer Vorrichtung gemäss Fig. 1, die aus den oben genannten Materialien gefertigt war, wurden in einem Vakuumofen zwischen zwei Flächenheizelementen Legierkontakte mit Vorbiegung hergestellt und ausgemessen. Für Scheiben (Si und Mo) mit einem Durchmesser von 38 mm und einer Dicke des Mo-Metallsubstrats von 1 mm ergab sich mit Vorbiegung anstelle der ursprünglichen Verwölbung von s = 135 μm (Fall 2 in Tabelle 1) nunmehr eine Verwölbung von s = 90 μm. Dass hierbei die gewünschte Obergrenze von s = 50 μm nicht unterschritten wurde, lag lediglich daran, dass in dieser Konfiguration aus Platzgründen die mit dem Wärmedehnelement maximal erreichbare Verbiegung auf 45 μm begrenzt war.

Mit einer geringen zusätzlichen Vorbiegung durch Eindrehen des Schraubverschlusses konnte daher die Verwölbung auch um weitere 10 μm auf s = 80 μm verringert werden.

Das Verwölbungsprofil, d.h. die Aenderung ..s der Verwölbung entlang dem Scheibendurchmesser (Koordinate x), wie es in den genannten Fällen gemessen worden ist, ist in Fig. 3 wiedergegeben. Die Kurve A stellt das Verwölbungsprofil für den Schichtverbund (Scheibendurchmesser: 38 mm; Dicke Mo-Scheibe: 1 mm) ohne Vorbiegung dar, Kurve B das Verwölbungsprofil mit der Vorbiegung durch das Wärmedehnelement 3 und den Schraubverschluss 2.

Dass die hierbei auftretenden Absolutwerte der Verwölbung s in der Scheibenmitte (x = 19 mm) von 167 bzw. 103 μm nicht mit den oben aufgeführten Werten von 135 bzw. 80 μm übereinstimmen, ist auf die in beiden Fällen unterschiedlichen Messmethoden zurückzuführen.

Wie man aus Kurve B entnehmen kann, enthält der vorgebogene Schichtverbund einen Bereich konvexer Verkrümmung in der Mitte der Scheibe. Eine solche konvexe Verkrümmung deutet darauf hin, dass sich die Vorzeichen der Spannungsverteilungen in Si-und Mo-Scheiben umkehren. Dadurch entstehen Zugspannungen in der Si-Scheibe, die möglichst vermieden werden sollen.

Die konvexe Verkrümmung ist eine unmittelbare Folge der mit dem Druckstempel 8 aus Fig. 1 erzeugten punktförmigen Belastung in der Scheibenmitte (schematische Darstellung in Fig. 2A), bei der das

5

Biegemoment M, aufgetragen entlang dem Scheibendurchmesser, in der Scheibenmitte ein punktförmiges Maximum aufweist.

Als geeignete Massnahme zur Vermeidung der konvexen Verkrümmung kann die punktförmige Belastung in der Scheibenmitte durch eine ringförmige Belastung im Sinne eines konstanten Biegemoments M in dem belasteten Bereich der Scheibenfläche ersetzt werden. Im Querschnitt durch die Scheibe ist dies eine Vierpunktbelastung (Fig. 2B).

Diese ringförmige Belastung kann durch einen Druckstempel 8 (Fig. 2B) realisiert werden, der zylindrisch aus der Oberfläche des Schraubverschlusses 2 herausragt und mit einem Kugelsegment abschliesst, welches den Krümmungsradius der vorgebogenen Scheiben hat. Der Durchmesser des Zylinders bestimmt dann den Flächenbereich mit konstantem Biegemoment M.

Aus dem bisher Gesagten geht hervor, dass sich mit dem erfindungsgemässen Verfahren Schichtverbunde und insbesondere mit Legierkontakt versehene Leistungs-Halbleiterbauelemente herstellen lassen, die zumindest eine verringerte Verwölbung nach dem Legieren zeigen. Der Schichtverbund ist jedoch deswegen nicht notwendigerweise spannungsfrei.

Eingehende rechnerische Spannungsanalysen haben aber ergeben, dass die Spannungen durch Anwendung der Vorbiegung nicht einfach innerhalb des Schichtverbunds nur umverteilt werden, sondern sich maximal um mehr als einen Faktor 3 reduzieren. Bei vollständiger Kompensation der Verwölbung durch eine entsprechende Vorbiegung mit kostantem Biegemoment M ist der legierte Schichtverbund bei Raumtemperatur nicht nur plan, sondern auch spannungsfrei.

Dies gilt allerdings nicht am Scheibenrand, wo im wesentlichen Scherspannungen auftreten. Diese Scherspannungen können vorzugsweise dadurch beseitigt werden, dass ein schmaler Rand des Schichtverbunds, insbesondere in einer Breite, die dem 3-fachen der Dicke des Schichtverbunds entspricht, entfernt wird (z.B. durch Sägen, Schleifen oder Sandstrahlen). Beim Abtrennen des Randes kann gleichzeitig eine geeignete Randkontur am Halbleitersubstrat angebracht werden, wie sie zur Verbesserung der Sperrfähigkeit üblich ist.

Der kompakte Aufbau der Vorrichtung gemäss Fig. 1 sowie deren geringe thermische Masse und gute Zugänglichkeit für Wärmestrahlung lassen diese Vorrichtung besonders geeignet erscheinen für den Einsatz in einem Legierofen, bei dem im Vakuum zwischen zwei grossflächigen Flächenheizelementen, insbesondere in Form von stromdurchflossenen Graphitfolien, die erhöhten Temperaturen für die stoffschlüssige Verbindung durch reinen Strahlungsaustausch erzeugt werden.

Für eine entsprechende Temperaturmessung kann dabei im Gehäuse 1 eine Thermometerbohrung 7 (Fig. 1) vorgesehen werden, durch die hindurch z.B. ein Thermoelement in den Innenraum eingeführt wird.

Schliesslich soll noch angemerkt werden, dass die Belastung der Scheibenanordnung beim Vorbiegen nach den bisher gemachten Erfahrungen dazu führt, dass die Lotmengen, die für eine stoffschlüssige Verbindung der Scheiben gebraucht werden, sich verringern. Im Falle des Si-Mo-Verbundes durch Al-Lot hätte dies zur Folge, dass weniger Si im Lot gelöst würde und die Aufschmelzzone nicht mehr so tief in das Halbleitersubstrat eindringen und dort flache PN-Uebergänge gefährden könnte.

Insgesamt stehen mit der Erfindung ein Verfahren und eine Vorrichtung zur Verfügung, die folgende Vorteile aufweisen:

- Die Vorrichtung ist einfach aufgebaut und hat einen geringen Raumbedarf;
- die Vorbiegetechnik kann ohne Probleme in spezielle Legierverfahren (Flächenheizelemente!) eingepasst werden;
- beim Si-Mo-Verbund kann die Menge des Al-Lots verringert werden (Schutz flacher PN-Uebergänge);
- höhere Zuverlässigkeit von Leistungs-Halbleiterbauelementen mit Legierkontakt im Betrieb durch verringerte mechanische Spannungen;
- Legierkontakte bei noch grösseren Bauelementen von mehr als 3″ Durchmesser möglich;
- Verwendung von dünnen und kostengünstigen Metallsubstraten (Mo) möglich;
- problemloser Einsatz von Maskenverfahren nach dem Legieren (beim GTO-Thyristor); und
- Anwendung der Legiertechnik auch bei sehr fein strukturierten Bauelementen, bei denen für die letzten Herstellungsschritte keine Verwölbung toleriert werden kann.


## Ansprüche

1. Verfahren zum Herstellen eines Schichtverbunds aus wenigstens zwei dünnen Scheiben unterschiedlicher Wärmeausdehnung, bei welchem Verfahren die Scheiben bei erhöhten Temperaturen über die gesamte Scheibenfläche stoffschlüssig verbunden und anschliessend abgekühlt werden, dadurch gekennzeichnet, dass die beim Abkühlen des stoffschlüssig verbundenen Schichtverbunds auftretende Verbiegung durch eine beim Verbindungsvorgang anliegende, in der Richtung entgegengesetzte Vorbiegung zumindest teilweise kompensiert wird.

2. Verfahren nach Anspruch 1, dadurch gekennzeichnet, dass zum Erzeugen der Vorbiegung die unterschiedliche Wärmeausdehnung zweier Materialien mit unterschiedlichen Wärmeausdehnungskoeffizienten verwendet wird.

3. Verfahren nach Anspruch 2, dadurch gekennzeichnet, dass zum Erzeugen der Vorbiegung die Anordnung der beiden Scheiben auf der einen Seite am Scheibenrand gehalten und von der anderen Seite her in der Scheibenmitte einer punktförmigen Belastung unterworfen sind.

4. Verfahren nach Anspruch 2, dadurch gekennzeichnet, dass zum Erzeugen der Vorbiegung die Anordnung der beiden Scheiben auf der einen Seite am Scheibenrand gehalten und von der anderen Seite her im Innenbereich einer ringförmigen Belastung unterworfen wird, derart, dass in dem belasteten Bereich der Scheibenfläche ein konstantes Biegemoment herrscht.

5. Verfahren nach Anspruch 2, dadurch gekennzeichnet, dass

a) die eine Scheibe ein Halbleitersubstrat (5), insbesondere ein Leistungs-Halbleiterbauelement aus Si, ist;

b) die andere Scheibe ein Metallsubstrat (4), insbesondere aus Mo, ist; und

c) für die stoffschlüssige Verbindung zwischen Halbleitersubstrat (5) und Metallsubstrat (4) ein Lot, insbesondere Al, verwendet wird.

6. Verfahren nach Anspruch 5, dadurch gekennzeichnet, dass nach dem Abkühlen ein schmaler Rand des Schichtverbunds, vorzugsweise in einer Breite, die dem 3-fachen der Dicke des Schichtverbunds entspricht, entfernt wird.

7. Verfahren nach Anspruch 5, dadurch gekennzeichnet, dass der Durchmesser der Scheiben mehrere Zentimeter beträgt und die Dicke des Metallsubstrats (4) kleiner als 5 mm, vorzugsweise kleiner gleich 2,5 mm ist.

8. Verfahren nach Anspruch 5, dadurch gekennzeichnet, dass die erhöhten Temperaturen für die stoffschlüssige Verbindung durch Erwärmen der Scheiben-Anordnung im Vakuum zwischen zwei grossflächigen Flächenheizelementen, vorzugsweise stromdurchflossenen Graphitfolien, erzeugt werden.

9. Vorrichtung zur Durchführung des Verfahrens nach Anspruch 1, umfassend

a) ein im wesentlichen ringförmiges Gehäuse (1) aus einem Material geringerer Wärmeausdehnung;

b) ein konzentrisch in dem Gehäuse (1) angeordnetes ringförmiges Wärmedehnelement (3) aus einem Material grösserer Wärmeausdehnung, welches die Anordnung der Scheiben auf der einen Seite am Scheibenrand abstützt; und

c) einen dem Wärmedehnelement (3) gegenüberliegenden Schraubenverschluss (2), welcher mit einem auf seiner Innenseite angeordneten Druckstempel (8) auf die vom Wärmedehnelement (3) abgestützte Anordnung der Scheiben drückt.

10. Vorrichtung nach Anspruch 9, dadurch gekennzeichnet, dass

a) das Gehäuse (1) aus einer Molybdänbasislegierung und

b) das Wärmedehnelement (3) aus einer Nickelbasislegierung bestehen; und

c) der Druckstempel (8) eine Druckfläche in Form eines Kugelsegments aufweist.

FIG.1

FIG.2A

FIG.2B

Biegemoment
M

Biegemoment
M

Verwölbung
Δs(μm)

200

167μm

103μm

100

A

B

s

0              19              38

x(mm)

FIG.3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | FR-A-2 487 577  (LE SILICIUM SEMICONDUCTEUR)<br>* Figuren 1,2; Anspruch 1; Seite 2, Zeile 29 - Seite 3, Zeile 19 *<br>----- | 1,5 | H 01 L  21/60 |
| | | | **RECHERCHIERTE SACHGEBIETE (Int. Cl.4)**<br><br>H 01 L |

Der vorliegende Recherchenbericht wurde für alle Patentansprüche erstellt

| Recherchenort | Abschlußdatum der Recherche | Prüfer |
|---|---|---|
| DEN HAAG | 07-06-1988 | DE RAEVE R.A.L. |